# EUROPÄISCHE PATENTSCHRIFT

(11) **EP 3 542 399 B1**
(45) Veröffentlichungstag und Bekanntmachung des Hinweises auf die Patenterteilung: **08.03.2023**
(21) Anmeldenummer: 17791045.2
(22) Anmeldetag: 23.10.2017
(51) Int. Cl.: H01L 25/16, H01L 33/64, H05K 1/02, H05K 1/18

(54) **LEISTUNGSMODUL MIT VERRINGERTER DEFEKTANFÄLLIGKEIT UND VERWENDUNG DESSELBEN**
POWER MODULE THAT IS LESS PRONE TO FAULTS, AND USE THEREOF
MODULE DE PUISSANCE À VULNÉRABILITÉ AUX DÉFAUTS RÉDUITE ET SON UTILISATION

(30) Priorität: 16.11.2016 DE 102016122014
(43) Veröffentlichungstag der Anmeldung: 25.09.2019
(73) Patentinhaber: TDK Electronics AG, 81671 München (DE)
(72) Erfinder: FEICHTINGER, Thomas, 8010 Graz (AT)
(74) Vertreter: Epping - Hermann - Fischer
(86) Internationale Anmeldenummer: PCT/EP2017/077010
(87) Internationale Veröffentlichungsnummer: WO 2018/091230

(56) Entgegenhaltungen:
- WO-A1-2013/190717
- DE-A1-102008 024 480
- DE-A1-102014 115 375
- US-A1- 2010 288 536
- US-A1- 2011 188 161
- US-A1- 2012 241 810

## Beschreibung

Die Erfindung betrifft Leistungsmodule, deren Defektanfälligkeit verringert ist, und die Verwendung solcher Module.

Immer mehr elektrische und elektronische Komponenten finden in technischen Geräten Verwendung. Entsprechend steigen deren Komplexität und damit die Zahl der Möglichkeiten eines Defekts. Zusätzlich hält der Trend zur Miniaturisierung weiter an, wodurch der Bauraum zur Realisierung elektrischer und elektronischer Funktionen immer kleiner wird.

Elektrische und elektronische Funktionen werden oft durch elektrische Module realisiert. Ein Modul fasst im Allgemeinen mehrere elektrische Komponenten, z. B. Chips, auf einem Trägersubstrat zusammen. Solche Module sind z. B. aus den Druckschriften US 2009/0129079 A1 und US 2008/0151547 A1 bekannt.

Aus der DE 102008024480 A1 sind elektrische Bauelemente mit einem Halbleiterbauelement und einem Träger bekannt. Aus der US 2010/288536 A1 sind keramische Leiterplatten mit einer Ausnehmung und mit in die Ausnehmung eingesetzter Schaltungskomponente bekannt. Aus der US 2012/241810 A1 sind Leiterplatten mit Kühlerblock mit einem Heizelement in einer Ausnehmung in der Leiterplatte bekannt.

Leistungsmodule, z. B. Leuchtmittel zur Straßenbeleuchtung (Fernlicht, Abblendlicht) in Kraftfahrzeugen, zeichnen sich im Vergleich zu Systemen, welche lediglich elektrische Signale verarbeiten, durch hohe elektrische Leistungen aus. Entsprechend beträgt auch die Abwärme ein Vielfaches der Abwärme signalverarbeitender Module.

Ein Problem bei bekannten Leistungsmodulen ist die Defektanfälligkeit und eine thermische Beschränkung der Leistungsfähigkeit.

Es besteht deshalb der Wunsch nach Leistungsmodulen mit verringerter Defektanfälligkeit, höherer Leistungsfestigkeit und höherer Leistungsfähigkeit, die dem anhaltenden Trend zur Miniaturisierung gehorchen und kleinere Abmessungen ermöglichen.

Diese Aufgabe wird durch das Leistungsmodul gemäß unabhängigem Anspruch 1 gelöst. Abhängige Ansprüche geben vorteilhafte Ausgestaltungen der Erfindung an.

Das Leistungsmodul umfasst ein Trägersubstrat mit einer dielektrischen Lage, einer Metallisierungslage und einer Ausnehmung, sowie eine Vielzahl elektrischer Funktionselemente. In der Metallisierungslage ist eine elektrische Leitung als Signalleitung oder Leistungsleitung strukturiert und die Vielzahl der Funktionselemente ist mit der elektrischen Leitung verschaltet. Die Vielzahl der Funktionselemente ist in der Ausnehmung angeordnet und jedes der Funktionselemente umfasst eine Wärmebrücke mit einem ESD-Schutzelement, die eine höhere Wärmeleitfähigkeit als das Trägersubstrat hat. Die jeweiligen Wärmebrücken sind mit dem jeweiligen ESD-Schutzelement aus dem gleichen Material gebildet und die Vielzahl der elektrischen Funktionselemente sind in einer Matrixanordnung in Zeilen und Spalten angeordnet.

Die Ausnehmung kann dabei eine durch das Trägersubstrat gehende Öffnung sein, sodass die Ausnehmung von beiden Seiten des Trägersubstrats zugänglich ist. Alternativ kann die Ausnehmung auch eine Vertiefung in Form eines Sacklochs sein, die das Trägersubstrat nicht durchdringt. Dann ist die Ausnehmung lediglich von der Oberseite des Trägersubstrats zugänglich. In letzterem Fall hat die Ausnehmung eine Unterseite, die durch eine Oberfläche des Trägersubstrats gebildet ist.

Neben der einen dielektrischen Lage und der einen Metallisierungslage kann das Trägersubstrat eine oder mehrere weitere dielektrische Lagen und eine oder weitere Metallisierungslagen aufweisen. Die dielektrischen Lagen trennen die Metallisierungslagen. In den Metallisierungslagen können elektrische Strukturen, z. B. Signalleitungen, Leistungsleitungen, Schaltungselemente wie kapazitive, induktive oder resistive Elemente, strukturiert sein.

Die Funktionselemente sind elektrische oder elektronische Leistungselemente, die im Betrieb eine relativ hohe elektrische Leistung umsetzen und eine entsprechend hohe Menge an Energie dissipieren. Das Funktionselement stellt jeweils somit eine Wärmequelle während des Betriebs dar. Als Funktionselemente kommen insbesondere Elemente mit Strukturen für Hochleistungs-LEDs (LED = Light Emitting Diode = Leuchtdiode) in Frage.

Zusätzlich zu den Strukturen, die als Wärmequelle agieren und elektrische Energie teilweise in Wärme umwandeln, hat das Funktionselement seine Wärmebrücke mit der hohen Wärmeleitfähigkeit. Im Vergleich zu konventionellen Leistungsmodulen mit Wärmequellen in Chips auf einem Trägersubstrat ist durch die Anordnung in der Ausnehmung das Material am Trägersubstrat, durch das die Wärme abgeführt werden muss reduziert. Durch das zusätzliche Vorhandensein der Wärmebrücken, die das Abführen von Wärme durch die höhere Wärmeleitfähigkeit als das Trägersubstrat weiter verbessern, ist die thermische Belastung der Energie dissipierenden Strukturen im Funktionselement doppelt verringert.

Der Temperaturbereich, in dem Kraftfahrzeuge eingesetzt werden, ist sehr breit. Vor allem bei Tagfahrlichtern, die nicht nur in der eher kühleren Dunkelheit eingesetzt werden, und die im Allgemeinen auf LEDs mit dotiertem Halbleitermaterial basieren, profitieren von einer verbesserten Wärmeabfuhr. Das Altern von Halbleiterbauelementen ist ein thermodynamischer Prozess mit exponentieller Temperaturabhängigkeit. Eine deutliche Verringerung der thermischen Belastung kann die Lebensdauer eines entsprechenden Bauelements deshalb vervielfachen und die Defektanfälligkeit reduzieren.

Durch das Anordnen der Funktionselemente in der Ausnehmung ist zusätzlich die Bauhöhe des Moduls reduziert.

Paradoxerweise beruht die Verringerung der Defektanfälligkeit somit gerade auf der Verkleinerung des Bauvolumens.

Insgesamt ist damit ein Leistungsmodul angegeben, das für Leistungsbauelemente, z. B. thermisch empfindliche Leistungshalbleiter, hoher Leistung gut geeignet ist. Die Defektanfälligkeit ist verringert. Temperaturschwankungen sind aufgrund des allgemein geringeren Temperaturniveaus verringert. Durch die verbesserte Wärmeabfuhr ist die Leistungsfestigkeit erhöht und eine entsprechende elektrische Komponente kann bei höherer Leistung betrieben werden. Die Funktionselemente in der Ausnehmung können mit den seitlichen Wänden der Ausnehmung mechanisch fest verbunden werden, sodass trotz der die mechanische Stabilität des Substrats prinzipiell gefährdenden Ausnehmung ein mechanisch robustes Modul erhalten wird. Die Abmessungen, insbesondere die Bauhöhe, sind verringert. Durch die Möglichkeit der geringeren Abmessungen ist die Zahl der Freiheitsgrade beim Designen entsprechender Module erhöht, was wiederum Raum für Maßnahmen zur Erleichterung der Verarbeitbarkeit der Module lässt.

Im Übrigen wurde erkannt, dass die Wärmebrücken auch so ausgebildet werden können, dass Strukturen zum Schutz des Moduls gegen Überspannungen erhalten werden, wodurch nicht nur die Defektanfälligkeit gegenüber thermisch induzierten Defekten, sondern auch die Defektanfälligkeit gegenüber gefährlichen elektrischen Impulsen verringert ist.

Es ist deshalb entsprechend möglich, dass jede Wärmebrücke dazu vorgesehen ist, während des Betriebs erzeugte Wärme, z. B. dissipierte elektrische Energie, an die Unterseite des Leistungsmoduls abzuführen.

Das Leistungsmodul kann auf einer Montageplatte befestigt sein, über die die erzeugte Wärme leicht an die Umgebung des Moduls abgeführt werden kann.

Es ist möglich, dass jede Wärmebrücke ein keramisches Material umfasst.

Das keramische Material kann dabei ein dielektrisches Material sein, das Leistungsstrukturen der Funktionselemente gegenüber seiner Umgebung isoliert und dennoch eine gute thermische Anbindung an die Unterseite des Leistungsmoduls ermöglicht.

Es ist möglich, dass jede Wärmebrücke ein Material umfasst oder aus dem Material besteht, wobei das Material ausgewählt ist aus ZnO-Bi (mit Bismut dotiertes Zinkoxid), ZnO-Pr (mit Praseodym dotiertes Zinkoxid), AlN (einem Aluminiumnitrid), Al₂O₃ und SiC (Siliziumcarbid) .

Das Trägersubstrat kann die üblichen Materialien, die für PCB (PCB = Printed Circuit Board) verwendet werden, umfassen. Das Trägersubstrat kann z. B. ein Multilayer-FR4-Substrat sein. Alternativ kann das Trägersubstrat auch ein IMS-Substrat (IMS = Insulated Metal Substrate) sein. Die thermische Leitfähigkeit bekannter Trägersubstrate ist im Wesentlichen auf 8 W/mK oder weniger beschränkt. Bismut dotiertes Zinkoxid hat eine thermische Leitfähigkeit von 20 W/mK oder mehr. Mit Praseodym dotiertes Zinkoxid hat eine thermische Leitfähigkeit von 40 W/mK oder mehr. Aluminiumnitrid hat eine thermische Leitfähigkeit von 100 W/mK oder mehr. Das heißt, dass - zusammen mit der verringerten Masse, durch die Wärme abgeführt werden muss - die thermische Anbindung um eine Größenordnung oder mehr verbessert sein kann.

Es ist möglich, dass jede Wärmebrücke einen Mehrschichtaufbau umfasst. Der Mehrschichtaufbau kann eine dielektrische Lage und ein Metallisierungslage haben. Zusätzlich zu dieser dielektrischen Lage könnendie Wärmebrücken weitere dielektrische Lagen haben. Zusätzlich zur Metallisierungslage können die Wärmebrücken weitere Metallisierungslagen haben.

In den Lagen des Mehrschichtaufbaus können elektrische Funktionen realisiert sein. Vorzugsweise sind das dielektrische Material und das Material der Metallisierungslagen so gewählt, dass eine optimale Wärmeabfuhr durch die gesamte Wärmebrücke gegeben ist.

Es ist möglich, dass die Wärmebrücken jeweils ein ESD-Schutzelement (ESD = Electro-Static Discharge) umfassen.

Das ESD-Schutzelement kann dabei funktionelle Strukturen des Funktionselements vor schädlichen Spannungsimpulsen schützen.

Es ist dazu möglich, dass jede Wärmebrücke einen Varistor umfasst.

Jede Wärmebrücke kann dazu einen Mehrschichtaufbau umfassen, in dem übereinander angeordnete und von dielektrischem Material getrennte erste Elektroden strukturiert sind. Zwischen den ersten Elektroden sind in weiteren Metallisierungslagen von den ersten Elektroden getrennte zweite Elektrodenflächen strukturiert.

Das dielektrische Material in Form einer Varistorkeramik hat dabei einen elektrischen Widerstand, der von der an den Elektroden anliegenden Spannung abhängt. Unerwünschte Überspannungspulse können dadurch leicht an ein Schutzpotenzial, z. B. ein Massepotenzial, abgegeben werden, während das dielektrische Material bei den üblichen Betriebsspannungen des Funktionselements einen Isolator darstellt.

Das Leistungsmodul kann neben den Funktionselementen noch weitere zusätzliche Funktionselemente mit gleichem oder ähnlichem Aufbau aufweisen, die ebenso in der Ausnehmung oder in zusätzlichen Ausnehmungen angeordnet sein können. Durch eine solche Anordnung wird ein hoher Grad an Integration erhalten. Je höher der Integrationsgrad und damit die Zahl der integrierten Funktionselemente sind, desto höher ist die Ausfallwahrscheinlichkeit. Es wäre unerwünscht, wenn ein Leistungsmodul aufgrund des Ausfalls eines einzelnen Funktionselements unbrauchbar würde. Durch die Möglichkeit eines wie oben beschriebenen ESD-Schutzes kann somit ein hochintegriertes Bauelement mit einer Vielzahl an hohe Leistung umsetzenden Funktionselementen erhalten werden und dennoch eine Ausfallwahrscheinlichkeit auf ein Minimum reduziert sein.

Es ist möglich, dass jedes dao Funktionselement funktionale Strukturen umfasst, die zum Aussenden von Licht anregbar sind.

Die funktionalen Strukturen sind dabei vorzugsweise an der Oberseite des Funktionselements angeordnet, während die Wärmebrücke die funktionalen Strukturen an die Unterseite des Funktionselements, z. B. an die Unterseite des Leistungsmoduls, thermisch anbindet. Zum Aussenden von Licht anregbaren Strukturen können insbesondere auf Halbleitermaterial basierende LED-Strukturen sein, denn solche Halbleiterstrukturen sind besonders empfindlich gegenüber Überhitzung.

Es ist möglich, dass das Trägersubstrat und/oder die Funktionselemente vertikale Durchkontaktierungen, so genannte Vias, haben. Vertikale Durchkontaktierungen verschalten dabei unterschiedliche Metallisierungslagen bzw. die in den unterschiedlichen Metallisierungslagen strukturierten Schaltungselemente. Solche Durchkontaktierungen ermöglichen es, sämtliche elektrischen Anschlüsse des Leistungsmoduls auf einer einzigen Seite, z. B. der Unterseite, anzuordnen. Entsprechend ist es auch möglich, dass die Funktionselemente alle elektrischen Verbindungen zum Trägersubstrat an seiner Unterseite haben. Dann sind die Funktionselemente in der Ausnehmung auf einer Lage des Trägersubstrats angeordnet und über strukturierte Leitungen verschaltet.

Bekannte IMS-Substrate mit vollflächig ausgebildeten metallisierten Lagen zwischen dielektrischen Lagen würden eine solche Kontaktierung nicht erlauben, da entsprechend ausgeführte Durchkontaktierungen in vertikaler Richtung durch die großflächig ausgebildeten Metalllagen kurzgeschlossen würden. Kontaktierungen zwischen der Oberseite und der Unterseite des Trägersubstrats sind bei solchen bekannten Substraten deshalb nicht möglich.

Es ist möglich, dass eine elektrische Verbindung zwischen der elektrischen Leitung des Trägersubstrats und den Funktionselementen bezüglich der thermischen Ausdehnung kompensiert ist. Trotz der verbesserten thermischen Anbindung der funktionalen Strukturen der Funktionselemente an die Unterseite des Leistungsmoduls können Temperaturdifferenzen innerhalb des Leistungsmoduls auftreten. Unterschiedliche Materialien im Leistungsmodul haben im Allgemeinen unterschiedliche thermische Ausdehnungskoeffizienten, weshalb ein Ausbilden von Temperaturgradienten im Modul ohne weitere Maßnahmen zu thermisch induzierten mechanischen Spannungen führt.

Die Kompensation unterschiedlicher thermischer Ausdehnungen bewirkt dadurch eine Verringerung der mechanischen Spannungen und dadurch eine Verringerung der mechanischen Belastungen auf die elektrischen Verbindungsstellen zwischen Trägersubstrat und Funktionselement. Neben der verringerten Defektanfälligkeit durch die Verringerung der thermischen Belastung des Funktionselements und der Verringerung der Defektanfälligkeit durch den Schutz vor unerwünschten elektrischen Impulsen ist somit auch die Defektanfälligkeit gegenüber mechanischen Schäden der Verbindungsstellen zwischen Substrat und Funktionseinheit verringert.

Eine bevorzugte Möglichkeit der Kompensation der thermischen Ausdehnungen besteht darin, das gleiche Material für elektrisch leitende Strukturen an der Unterseite jedes Funktionselements und für elektrisch leitende Strukturen an der Oberseite der Ausnehmung zu verwenden.

Dabei sind insbesondere Materialien bevorzugt, die ein isotropes thermisches Ausdehnungsverhalten zeigen und deren Tensor des Ausdehnungskoeffizienten nur Diagonalelemente hat, die von Null verschieden und gleich sind.

So ist es möglich, an der Unterseite jedes Funktionselements und an der Oberseite des Trägersubstrats in der Ausnehmung und für Verbindungen, z. B. Bump-Verbindungen, dazwischen nur Kupfer oder nur Silber zu verwenden.

Es ist ferner möglich, dass das Leistungsmodul einen Temperaturpuffer umfasst. Die Funktionselemente können in vertikaler Richtung von der Unterseite der Ausnehmung, die durch die dortige lokale Oberseite des Trägersubstrats gebildet wird, oder in horizontaler Richtung von Seitenwänden der Ausnehmung beabstandet sein. Entsprechend existiert ein vertikaler Spalt neben den Funktionselementen oder ein horizontaler Spalt zwischen den Funktionselementen und dem "Boden" der Ausnehmung. Dieser Spalt kann durch das Material des Temperaturpuffers ausgefüllt sein. In horizontaler Richtung kann das Funktionselement einen ersten Koeffizienten aufweisen. Das Trägersubstrat kann in der horizontalen Richtung einen zweiten, vom ersten Koeffizienten verschiedenen Temperatur-Ausdehnungskoeffizienten haben. Bei Temperaturänderung ändern sich die Breiten jedes Funktionselements und der Ausnehmung unterschiedlich stark. Entsprechend wird der Spalt größer oder kleiner. Der Temperaturpuffer hat vorzugsweise einen Temperatur-Ausdehnungskoeffizienten, der im Wesentlichen dem - rechnerisch leicht ermittelbaren - "Temperatur-Ausdehnungskoeffizienten" des Spalts entspricht. Das heißt, dass durch den Temperaturpuffer bei jeder Temperatur und bei Temperaturänderungen eine formschlüssige Verbindung zwischen Trägersubstrat und Funktionselement gegeben ist, wodurch die mechanische Stabilität des Leistungsmoduls erhöht ist. Insbesondere ist es möglich, dass die Temperatur-Ausdehnungskoeffizienten des Spalts und des Temperaturpuffers sich um 5 ppm/K oder weniger unterscheiden. Es ist möglich, dass das Leistungsmodul eine Treiberschaltung zur Ansteuerung der Funktionselemente umfasst. Die Treiberschaltung kann dabei auf oder über dem Trägersubstrat angeordnet oder im Trägersubstrat integriert sein. Die Treiberschaltung kann auch auf oder über den Funktionselementen angeordnet oder in den Funktionselementen integriert sein.

Hat das Leistungsmodul mehr als ein Funktionselement, so kann eine einzige Treiberschaltung mehrere oder alle Funktionselemente ansteuern. Alternativ ist es auch möglich, dass pro Funktionselement eine eigene Treiberschaltung vorgesehen ist oder dass es verschiedene Gruppen von Funktionselementen gibt und je eine Treiberschaltung für jede Gruppe an Funktionselementen vorgesehen ist.

Es ist möglich, dass das Leistungsmodul einen Sensor umfasst. Der Sensor kann auf oder über dem Trägersubstrat angeordnet oder im Trägersubstrat integriert sein. Es ist auch möglich, dass der Sensor auf oder über einem Funktionselement angeordnet ist oder in einem Funktionselement integriert ist.

Der Sensor kann insbesondere ein Temperatursensor sein, der das stets aktuelle Temperaturniveau des Funktionselements, des Trägersubstrats oder des gesamten Leistungsmoduls beobachtet und Temperaturwerte an die Treiberschaltung weiterleitet.

In der Treiberschaltung kann eine Schaltungslogik integriert sein, die die Aktivität der Vielzahl von Funktionselementen in Abhängigkeit von externen Steuersignalen und in Abhängigkeit vom gemessenen Wert des Sensors regelt oder steuert.

Erfindungsgemäß weist das Leistungsmodul eine Vielzahl von Funktionselementen auf Die Funktionselemente sind in einer regelmäßigen Anordnung zusammen in der Ausnehmung positioniert. Die Funktionselemente sind, erfindungsgemäß, in Zeilen und Spalten, also in einer Matrixanordnung, positioniert sein.

Entsprechend ist es möglich, dass das Leistungsmodul ein LED-Matrixmodul ist.

Es ist möglich, dass eine oder mehrere dielektrische Lagen des Trägersubstrats ein keramisches Material umfassen oder aus einem keramischen Material bestehen oder ein organisches Material umfassen oder aus einem organischen Material bestehen oder ein Glas umfassen oder aus einem Glas bestehen.

Als keramisches Material kommen z.B. AlN und Al₂O₃ in Frage. Als organisches Material kommt ein Harz in Frage. Als Glas kommen übliche Gläser in Frage.

Es ist auch möglich, dass das dielektrische Material im Trägersubstrat ein Standardmaterialen für Leiterplatten, z. B. Multilayer-Leiterplatten, z. B. FR4, ist.

Es ist möglich, dass das Leistungsmodul als Leuchtmittel, z. B. als Fernlicht, Abblendlicht oder Tagfahrlicht oder als Fahrtrichtungsanzeiger (Blinker) Verwendung findet.

Nachfolgend werden Funktionsprinzipien des Leistungsmoduls und ausgewählte Details von möglichen Ausführungsformen anhand der schematischen Figuren näher erläutert.

Es zeigen:
- Fig. 1:: die Position eines Funktionselements in einer Ausnehmung im Trägersubstrat,
- Fig. 2:: ein Funktionselement mit einer funktionalen Struktur und einer Wärmebrücke,
- Fig. 3:: eine Ausführung der Wärmebrücke mit einem Mehrlagenaufbau,
- Fig. 4:: die Anordnung des Funktionselements in einer Ausnehmung, die das Trägersubstrat vollständig durchdringt,
- Fig. 5:: eine Draufsicht auf eine Matrixanordnung von Funktionselementen,
- Fig. 6:: eine Anordnung mehrerer Funktionselemente gemeinsam in einer einzigen Ausnehmung,
- Fig. 7:: ein Funktionselement mit mehreren nebeneinander angeordneten funktionalen Strukturen und einem ESD-Schutz in der Wärmebrücke,
- Fig. 8:: ein Leistungsmodul mit einem Sensor,
- Fig. 9:: ein Leistungsmodul mit einer Treiberschaltung.

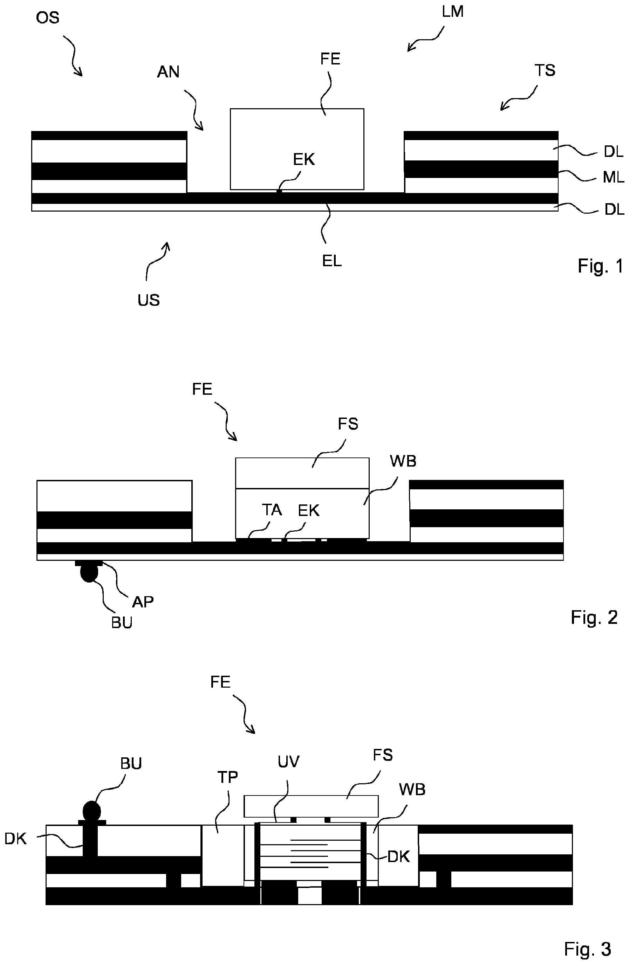

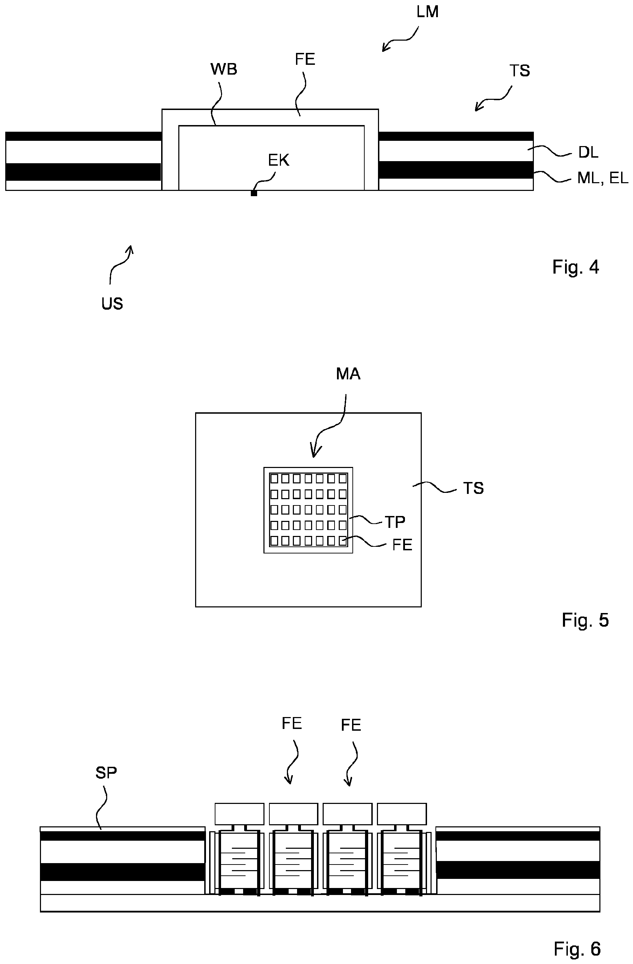

Die Ausführungsformen der Figuren 1-4 gehören nicht zur beanspruchten Erfindung. Sie werden aber zur Erläuterung der Erfindung nachfolgend besprochen. Die Figuren 5-9 zeigen Ausführungsformen der Erfindung.

Figur 1 zeigt den prinzipiellen Aufbaus eines Leistungsmoduls LM mit einem Trägersubstrat TS, welches mehrere Lagen aufweist. Dazu zählen insbesondere dielektrische Lagen DL aus einem isolierenden Material und Metallisierungslagen ML, in denen elektrische Strukturen gebildet sein können. Im Trägersubstrat TS gibt es eine Ausnehmung AN, in welcher das Funktionselement FE angeordnet ist. Die in Figur 1 gezeigte Ausnehmung hat die Form eines so genannten Sacklochs, d. h. die Ausnehmung hat einen Boden. Auf dem Boden der Ausnehmung sitzt das Funktionselement FE. Bei einem Leistungsmodul LM mit einer Ausnehmung AN, die nur in einer Richtung offen ist, ist die Seite, zu der die Ausnehmung AN offen ist, die Oberseite OS. Die gegenüberliegende Seite ist die Unterseite US. Das Funktionselement FE ist über einen elektrischen Kontakt EK mit der elektrischen Leitung EL, z. B. gebildet in einer Metallisierungslage, verschaltet.

Wärme, die im Funktionselement FE, insbesondere an der Oberseite des Funktionselements FE, gebildet wird, durchdringt das Funktionselement FE mit geringem Widerstand. Damit diese Wärme über die Unterseite US des Leistungsmoduls LM an eine externe Umgebung abgegeben werden kann, ist im Falle eines Sacklochs als Ausnehmung AN eine geringere Menge an Material des Trägersubstrats zu überwinden, als wenn das Funktionselement FE nicht in einer Ausnehmung, sondern auf der Oberseite OS des Trägersubstrats angeordnet wäre.

Entsprechend ist es auch bevorzugt, wenn die lokale Dicke des Trägersubstrats TS im Bereich der Ausnehmung AN geringer ist als lokal in einem Bereich ohne Ausnehmung.

Figur 2 zeigt eine Anordnung, bei der das Funktionselement FE zwei übereinander angeordnete Bereiche hat. Den oberen Bereich bildet ein Abschnitt mit funktionalen Strukturen FS, die z. B. eine elektrische oder elektronische oder optische Funktion realisieren. Darunter ist die Wärmebrücke WB angeordnet, die im oberen Abschnitt erzeugte Wärme an die Unterseite des Funktionselements FE und damit an die Unterseite des Leistungsmoduls führt.

Um einen Übertrag der Wärme an die Unterseite des Leistungsmoduls zu vereinfachen, ist die Wärmebrücke WB über eine thermische Ankopplung TA mit dem Boden der Ausnehmung verbunden. Über die thermische Ankopplung TA, z. B. gebildet durch Leitpaste oder eine Metallisierung, ist der thermische Widerstand verringert. Die thermische Ankopplung TA umfasst dabei vorzugsweise Materialien mit geringem thermischem Widerstand, z. B. Kupfer oder Silber.

An der Unterseite des Leistungsmoduls können Anschlusspads AP vorgesehen sein, die z. B. durch eine UBM (UBM = Under-Bump Metallization) gebildet sind. Über ein solches Anschlusspad kann das Leistungsmodul über eine Bump-Verbindung BU mit einer externen Umgebung verbunden und verschaltet sein.

Figur 3 zeigt Details eines Leistungsmoduls, bei dem die Wärmebrücke WB einen Mehrlagenaufbau hat. Darin sind dielektrische Lagen und Metallisierungslagen übereinander angeordnet. Eine solche Struktur leitet Wärme gut, wenn das Material der dielektrischen Lage entsprechend gewählt ist. Eine solche Wärmebrücke WB kann zusätzlich zum Abführen von Wärme eine elektrische oder elektrische Funktion bereitstellen. So ist es möglich, dass Elektroden in den Metallisierungslagen gebildet sind. Die Elektroden werden durch dielektrisches Material in vertikaler Richtung voneinander getrennt. In vertikaler Richtung benachbarte Elektroden sind unterschiedlichen Anschlüssen zugeordnet. Ist das dielektrische Material eine Varistorkeramik, so sind die beiden unterschiedlichen Anschlüsse bezüglich einer niedrigen elektrischen Spannung voneinander isoliert. Liegt an den beiden unterschiedlichen Anschlüssen eine hohe Spannung an, z. B. ein ESD-Puls, so zeigt die Varistorkeramik einen verringerten elektrischen Widerstand und der ESD-Puls kann an ein Referenzpotenzial abgeleitet werden.

Die Wärmebrücke WB hat vertikale Durchkontaktierungen DK (Vias), über die die funktionalen Strukturen FS an der Oberseite des Funktionselements mit strukturierten Metallisierungen des Trägersubstrats verschaltet sind.

Auch im mehrlagig ausgeführten Trägersubstrat gibt es Durchkontaktierungen DK, die Schaltungselemente oder Leitungen unterschiedlicher Metallisierungslagen miteinander verbinden. Über Durchkontaktierungen DK ist es möglich, dass alle externen Anschlüsse des Leistungsmoduls auf einer Seite des Leistungsmoduls angeordnet sind, was die Integration in eine externe Schaltungsumgebung erleichtert.

Der Mehrlagenaufbau des Funktionselements FE hat eine zusätzliche Umverdrahtung UV, um das elektrische Kontaktieren der funktionalen Strukturen an Anschlusskontakte an der Wärmebrücke WB zu vereinfachen.

In horizontaler Richtung ist das Funktionselement FE von den Seitenwänden der Ausnehmung beabstandet. Dieses Volumen ist durch Material eines Temperaturpuffers TP gefüllt, der einen Temperatur-Ausdehnungskoeffizienten hat, der so gewählt ist, dass die Zu- bzw. Abnahme des Puffers TP der Zu- bzw. Abnahme der Breite des Spalts gleicht.

Figur 4 zeigt eine Form eines Leistungsmoduls, bei dem die Ausnehmung das Trägersubstrat vollständig und im gesamten Bereich der Grundfläche durchdringt. Um die Gesamthöhe des Leistungsmoduls maximal zu verringern, ist das Funktionselement vollständig im Trägersubstrat eingebettet. Um die Integration in eine externe Umgebung zu vereinfachen und insbesondere um die Wärmeabgabe nach unten zu vereinfachen, sind die Unterseite des Funktionselements FE, insbesondere dessen Wärmebrücke WB, und die Unterseite US des Trägersubstrats bündig ausgerichtet, sodass eine im Wesentlichen glatte Unterseite des gesamten Leistungsmoduls erhalten wird.

Elektrische Kontakte an der Unterseite des Funktionselements können dann aus der Unterseite des Leistungsmoduls herausragen. Es ist alternativ auch möglich, dass das Funktionselement FE nur so weit in das Trägersubstrat eingebettet ist, dass die Unterseite des Trägersubstrats bündig mit der Unterseite der elektrischen Kontakte EK abschließt.

Figur 5 zeigt eine Draufsicht auf eine Matrixanordnung MA, in der eine Vielzahl an Funktionselementen FE in Zeilen und Spalten ausgerichtet ist.

Figur 6 illustriert die Möglichkeit, eine einzige Ausnehmung vorzusehen und eine Vielzahl an Funktionselementen FE darin anzuordnen. Jedes der Funktionselemente FE kann eine Wärmebrücke mit Mehrschichtaufbau und funktionalen Strukturen oberhalb der Wärmebrücke umfassen.

Die oberste Lage des Trägersubstrats kann ein Spiegel SP sein, der Licht reflektiert. Stellen die funktionalen Strukturen Lichtquellen dar, wird die gesamte Menge an abgestrahltem Licht des Leistungsmoduls erhöht, wenn weniger Licht durch die ansonsten passive Oberseite des Trägersubstrats absorbiert wird.

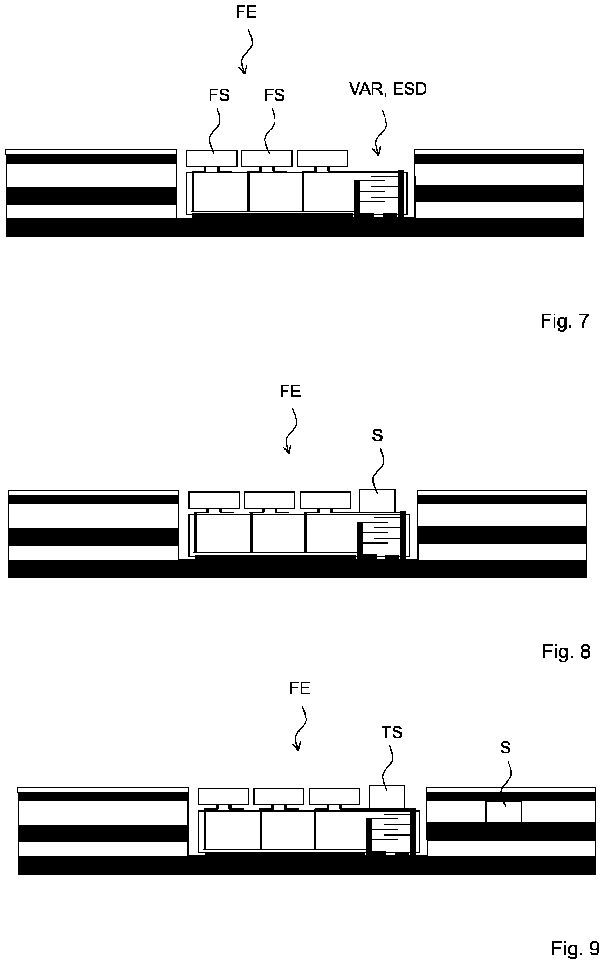

Figur 7 zeigt die Möglichkeit, mehrere funktionale Strukturen FS in einem einzigen Funktionselement FE vorzusehen. Die Wärmebrücke des Funktionselements FE hat einen Mehrschichtaufbau mit Varistormaterial und stellt eine ESD-Schutzfunktion zur Verfügung.

Figur 8 zeigt die Möglichkeit, einen Sensor direkt auf der Oberseite des Funktionselements FE anzuordnen. Alternativ kann der Sensor auch im Mehrlagenaufbau des Funktionselements oder auf oder im Trägersubstrat angeordnet sein.

So zeigt Figur 9 die Möglichkeit, den Sensor S im Inneren des Mehrlagenaufbaus des Trägersubstrats anzuordnen. Auf dem Funktionselement FE ist dagegen eine Treiberschaltung TSG angeordnet, um die funktionalen Strukturen anzusteuern und ihre Arbeitsweise zu steuern oder zu regeln. Die Treiberschaltung TSG kann dabei ebenfalls elektrische oder elektronische Leistungsbauelemente enthalten. Eine Anordnung auf der Wärmebrücke ist in diesem Fall bevorzugt.

Das Leistungsmodul und die Verwendung des Leistungsmoduls sind durch die beschriebenen technischen Merkmale und die gezeigten Details nicht beschränkt. Leistungsmodule mit zusätzlichen Schaltungselementen, zusätzlichen Anschlüssen und zusätzlichen Ausnehmungen sind ebenso im Schutzumfang enthalten, insoweit sie durch die folgenden Ansprüche definiert sind.

### Bezugszeichenliste

- AN:: Ausnehmung
- AP:: Anschlusspad
- BU:: Bump-Verbindung
- DK:: Durchkontaktierung
- DL:: dielektrische Lage
- EK:: elektrischer Kontakt
- EL:: elektrische Leitung
- ESD:: ESD-Schutz
- FE:: Funktionselement
- FS:: funktionale Struktur
- LM:: Leistungsmodul
- MA:: Matrix-Anordnung
- ML:: Metallisierungslage
- OS:: Oberseite
- S:: Sensor
- TA:: thermische Ankopplung
- TP:: Temperaturpuffer
- TS:: Trägersubstrat
- TSG:: Treiberschaltung
- US:: Unterseite
- UV:: Umverdrahtung
- VAR:: Varistor
- WB:: Wärmebrücke

## Patentansprüche

1. Leistungsmodul (LM), umfassend
· ein Trägersubstrat (TS) mit einer dielektrischen Lage (DL), einer Metallisierungslage (ML) und einer Ausnehmung (AN),
· eine Vielzahl elektrischer Funktionselemente (FE), wobei
· in der Metallisierungslage (ML) eine elektrische Leitung (EL) als Signalleitung oder Leistungsleitung strukturiert ist,
· die Vielzahl der Funktionselemente (FE) mit der elektrischen Leitung (EL) verschaltet ist,
· die Vielzahl der Funktionselemente (FE) in der Ausnehmung (AN) angeordnet ist und
· jedes der Funktionselemente (FE) eine Wärmebrücke (WB) mit einem ESD-Schutzelement umfasst, die eine höhere Wärmeleitfähigkeit als das Trägersubstrat (TS) hat,
· die jeweiligen Wärmebrücken (WB) mit dem jeweiligen ESD-Schutzelement aus dem gleichen Material gebildet sind,
· die Vielzahl der elektrischen Funktionselemente in einer Matrixanordnung in Zeilen und Spalten angeordnet sind.

2. Leistungsmodul nach dem vorherigen Anspruch, wobei jede Wärmebrücke (WB) dazu vorgesehen ist, während des Betriebs erzeugte Wärme an die Unterseite (US) des Leistungsmoduls (LM) abzuführen.

3. Leistungsmodul nach einem der vorherigen Ansprüche, wobei jede Wärmebrücke (WB) ein keramisches Material umfasst.

4. Leistungsmodul nach einem der vorherigen Ansprüche, wobei jede Wärmebrücke (WB) ein Material umfasst oder daraus besteht, das ausgewählt ist aus: ZnO-Bi, ZnO-Pr, AlN, Al₂O₃, SiC.

5. Leistungsmodul nach einem der vorherigen Ansprüche, wobei jede Wärmebrücke (WB) einen Mehrschichtaufbau mit einer dielektrischen Lage und einer Metallisierungslage umfasst.

6. Leistungsmodul nach einem der vorherigen Ansprüche, wobei jede Wärmebrücke (WB) einen Varistor umfasst.

7. Leistungsmodul nach einem der vorherigen Ansprüche, wobei jedes Funktionselement (FE) funktionale Strukturen (FS) umfasst, die zum Aussenden von Licht anregbar sind.

8. Leistungsmodul nach einem der vorherigen Ansprüche, wobei das Trägersubstrat (TS) und/oder die Funktionselemente (FE) vertikale Durchkontaktierungen (DK) haben.

9. Leistungsmodul nach einem der vorherigen Ansprüche, wobei eine elektrische Verbindung zwischen der elektrischen Leitung (EL) und den Funktionselementen (FE) bezüglich der thermischen Ausdehnung kompensiert ist.

10. Leistungsmodul nach dem vorherigen Anspruch, wobei elektrisch leitende Strukturen an der Unterseite jedes Funktionselements (FE) und an der Oberseite der Ausnehmung (AU) aus dem gleichen Material bestehen.

11. Leistungsmodul nach einem der vorherigen Ansprüche, ferner umfassend einen mit einem Temperaturpuffer (TP) gefüllten Spalt, der denselben Temperaturausdehnungskoeffizient wie der Spalt aufweist.

12. Leistungsmodul nach einem der vorherigen Ansprüche, ferner umfassend eine Treiberschaltung (TS) zur Ansteuerung der Funktionselemente (FE), die auf oder in dem Trägersubstrat (TS) oder auf oder in den Funktionselementen (FE) angeordnet ist.

13. Leistungsmodul nach einem der vorherigen Ansprüche, ferner umfassend einen Sensor (S), der auf oder in dem Trägersubstrat (TS) oder auf oder in dem Funktionselement (FE) angeordnet ist.

14. Leistungsmodul nach einem der vorherigen Ansprüche, das ein LED-Matrixmodul ist.

15. Leistungsmodul nach einem der vorherigen Ansprüche, wobei die dielektrische Lage (DL)
- ein keramisches Material umfasst oder aus einem keramischen Material besteht oder
- ein organisches Material umfasst oder aus einem organischen Material besteht oder
- ein Glas umfasst oder aus einem Glas besteht.

16. Verwendung eines Leistungsmoduls (LM) nach einem der vorherigen Ansprüche als Leuchtmittel in einem Fahrzeug.

## Claims

1. Power module (LM), comprising
· a carrier substrate (TS) having a dielectric layer (DL), a metallization layer (ML) and a cutout (AN),
· a multiplicity of electrical functional elements (FE),
wherein
in the metallization layer (ML) an electrical line (EL) is structured as signal line or power line,
· the multiplicity of functional elements (FE) are interconnected with the electrical line (EL),
· the multiplicity of functional elements (FE) are arranged in the cutout (AN), and
· each of the functional elements (FE) comprises a thermal bridge (WB) with an ESD protection element, said thermal bridge having a higher thermal conductivity than the carrier substrate (TS),
· the respective thermal bridges (WB) with the respective ESD protection element are formed from the same material,
· the multiplicity of electrical functional elements are arranged in rows and columns in a matrix arrangement.

2. Power module according to the preceding claim, wherein each thermal bridge (WB) is provided for dissipating heat generated during operation to the underside (US) of the power module (LM).

3. Power module according to either of the preceding claims, wherein each thermal bridge (WB) comprises a ceramic material.

4. Power module according to any of the preceding claims, wherein each thermal bridge (WB) comprises or consists of a material selected from: ZnO-Bi, ZnO-Pr, AlN, Al₂O₃, SiC.

5. Power module according to any of the preceding claims, wherein each thermal bridge (WB) comprises a multilayer structure with a dielectric layer and a metallization layer.

6. Power module according to any of the preceding claims, wherein each thermal bridge (WB) comprises a varistor.

7. Power module according to any of the preceding claims, wherein each functional element (FE) comprises functional structures (FS) which are excitable to emit light.

8. Power module according to any of the preceding claims, wherein the carrier substrate (TS) and/or the functional elements (FE) have/has vertical vias (DK) .

9. Power module according to any of the preceding claims, wherein an electrical connection between the electrical line (EL) and the functional elements (FE) is compensated with respect to thermal expansion.

10. Power module according to the preceding claim, wherein electrically conductive structures at the underside of each functional element (FE) and at the top side of the cutout (AU) consist of the same material.

11. Power module according to any of the preceding claims, furthermore comprising a gap filled with a temperature buffer (TP) having the same coefficient of thermal expansion as the gap.

12. Power module according to any of the preceding claims, furthermore comprising a driver circuit (TS) for driving the functional elements (FE), which is arranged on or in the carrier substrate (TS) or on or in the functional elements (FE).

13. Power module according to any of the preceding claims, furthermore comprising a sensor (S) arranged on or in the carrier substrate (TS) or on or in the functional element (FE).

14. Power module according to any of the preceding claims, which is an LED matrix module.

15. Power module according to any of the preceding claims, wherein the dielectric layer (DL)
- comprises a ceramic material or consists of a ceramic material or
- comprises an organic material or consists of an organic material or
- comprises a glass or consists of a glass.

16. Use of a power module (LM) according to any of the preceding claims as an illuminant in a vehicle.

## Revendications

1. Module de puissance (LM), comprenant
· un substrat de support (TS) pourvu d'une couche diélectrique (DL), d'une couche de métallisation (ML) et un évidement (AN),
· une pluralité d'éléments fonctionnels électriques (FE), dans lequel
une ligne électrique (EL) est intégrée dans la couche de métallisation (ML) sous forme de ligne de signal ou de ligne de puissance,
· la pluralité des éléments fonctionnels (FE) est interconnectée avec la ligne électrique (EL),
· la pluralité des éléments fonctionnels (FE) est disposée dans l'évidement (AN), et
chacun des éléments fonctionnels (FE) comprend un pont thermique (WB) pourvu d'un élément de protection ESD qui présente une conductivité thermique supérieure au substrat de support (TS),
· les ponts thermiques (WB) respectifs sont formés du même matériau avec l'élément de protection ESD respectif,
· la pluralité des éléments fonctionnels électriques est disposée dans un agencement matriciel par rangées et par colonnes.

2. Module de puissance selon la revendication précédente, dans lequel chaque pont thermique (WB) est prévu pour dissiper la chaleur produite pendant le fonctionnement vers la face inférieure (US) du module de puissance (LM).

3. Module de puissance selon l'une quelconque des revendications précédentes, dans lequel chaque pont thermique (WB) comprend un matériau céramique.

4. Module de puissance selon l'une quelconque des revendications précédentes, dans lequel chaque pont thermique (WB) comprend ou est composé d'un matériau qui est sélectionné parmi : ZnO-Bi, ZnO-Pr, AlN, Al₂O₃, SiC.

5. Module de puissance selon l'une quelconque des revendications précédentes, dans lequel chaque pont thermique (WB) comprend une structure multicouche avec une couche diélectrique et une couche de métallisation.

6. Module de puissance selon l'une quelconque des revendications précédentes, dans lequel chaque pont thermique (WB) comprend un variateur.

7. Module de puissance selon l'une quelconque des revendications précédentes, dans lequel chaque élément fonctionnel (FE) comprend des structures fonctionnelles (FS) qui peuvent être excitées pour émettre de la lumière.

8. Module de puissance selon l'une quelconque des revendications précédentes, dans lequel le substrat de support (TS) et/ou les éléments fonctionnels (FE) présentent des métallisations de trou verticales (DK).

9. Module de puissance selon l'une quelconque des revendications précédentes, dans lequel une liaison électrique entre la ligne électrique (EL) et les éléments fonctionnels (FE) est compensée en dilatation thermique.

10. Module de puissance selon la revendication précédente, dans lequel des structures électriquement conductrices sur la face inférieure de chaque élément fonctionnel (FE) et sur la face supérieure de l'évidement (AU) sont composées du même matériau.

11. Module de puissance selon l'une quelconque des revendications précédentes, comprenant en outre un intervalle rempli d'un tampon thermique (TP) qui présente le même coefficient de dilatation thermique que l'intervalle.

12. Module de puissance selon l'une quelconque des revendications précédentes, comprenant en outre un circuit pilote (TS) pour piloter les éléments fonctionnels (FE) qui sont disposés sur ou dans le substrat de support (TS) ou sur ou dans les éléments fonctionnels (FE).

13. Module de puissance selon l'une quelconque des revendications précédentes, comprenant en outre un capteur (S) qui est disposé sur ou dans le substrat de support (TS) ou sur ou dans l'élément fonctionnel (FE).

14. Module de puissance selon l'une quelconque des revendications précédentes qui est un module de matrice à LED.

15. Module de puissance selon l'une quelconque des revendications précédentes, dans lequel la couche diélectrique (DL)
- comprend un matériau céramique ou est composée d'un matériau céramique, ou
- comprend un matériau organique ou est composée d'un matériau organique, ou
- comprend du verre ou est composée de verre.

16. Utilisation d'un module de puissance (LM) selon l'une quelconque des revendications précédentes comme moyen d'éclairage dans un véhicule.
